# EUROPÄISCHE PATENTANMELDUNG

(11) **EP 4 811 939 A1**
(43) Veröffentlichungstag der Anmeldung: **23.09.2026**
(21) Anmeldenummer: 25165134.5
(22) Anmeldetag: 20.03.2025
(51) Int. Cl.: H05K 7/14

(54) **MODULTRÄGER ZUR AUFNAHME EINES ELEKTRONIKMODULS, INSBESONDERE FÜR EIN MODULAR AUFBAUBARES AUTOMATISIERUNGSSYSTEM**

(71) Anmelder: Siemens Aktiengesellschaft, 80333 München (DE)
(72) Erfinder: Auerswald, Christian, 09131 Chemnitz (DE); Traub, Andreas, 92224 Amberg (DE); Weigl, Simon, 93413 Cham (DE); Zurek, Frantisek, 09126 Chemnitz (DE)
(74) Vertreter: Siemens Patent Attorneys

(57) **Zusammenfassung**

Die Erfindung betrifft einen Modulträger (BC) ausgestaltet ein Elektronikmodul (EM) aufzunehmen, wobei zur Befestigung auf der Montageplatte (MP) im Bereich des oberen Endes (OE) ein erstes Befestigungsmittel (BT1) angeordnet ist und im Bereich des unteren Endes (UE) ein zweites Befestigungsmittel (BT2) angeordnet ist, dabei sind die Befestigungsmittel derart ausgestaltet, dass ein Betätigungsteil (BT1,BT2) beweglich in einem Führungsteil (FT1,FT2) angeordnet ist, wobei das Betätigungsteil (BT1,BT2) einen Rasthaken(RH) aufweist, welcher derart elastisch ausgebildet ist, dass in einer ersten Stellung (S1) des Betätigungsteils (BT1,BT2) eine Federkraft des Rasthakens(RH) eine am Ende des Rasthakens(RH) angeordnete Rastnase (RN) gegen eine Innenfläche des Führungsteils (FT1,FT2) drückt, wobei das Führungsteil (FT1,FT2) eine in der Montageseite (MS) angeordnete Ausnehmung (A) aufweist, wobei in einer zweiten Stellung (S2) des Betätigungsteils (BT1,BT2) der Rasthaken (RH) mit der Rastnase (RN) die Ausnehmung (A) und eine Öffnung (O) in der Montageplatte (MP) durchdringt, wobei zwischen der Montageseite (MS) innerhalb des Führungsteils (FT1,FT2) und dem Betätigungsteil (BT1,BT2) ein Rückstellmittel (RM) angeordnet ist, welches das Betätigungsteil (BT1,BT2) in Richtung der Aufnahmeseite (AS) derart zurückführt, dass das Betätigungsteil (BT1,BT2) in einer Verriegelungsstellung (SV) verharrt und die Rastnase (RN) gegen die Montageplatte (MP) drückt.

## Beschreibung

### EINLEITUNG

Die vorliegende Erfindung betrifft einen Modulträger zur Aufnahme eines Elektronikmoduls, insbesondere für ein modular aufbaubares Automatisierungssystem. Solche Modulträger werden beispielsweise in industriellen Steuerungssystemen eingesetzt, um verschiedene Elektronikmodule wie Ein-/Ausgabemodule oder Kommunikationsmodule aufzunehmen und auf einer Montageplatte zu befestigen.

Aus dem Stand der Technik, beispielsweise der EP 4 312 473 B1, sind bereits Modulträger für Automatisierungssysteme bekannt. Diese weisen jedoch Nachteile hinsichtlich der Flexibilität bei der Montage und der Anpassungsfähigkeit an unterschiedliche Leiterplattendicken auf.

### AUFGABE DER ERFINDUNG

Es ist Aufgabe der vorliegenden Erfindung, einen verbesserten Modulträger bereitzustellen, der eine einfache und flexible Montage auf Montageplatten unterschiedlicher Dicke ermöglicht, dabei einen zuverlässigen Toleranzausgleich bietet und gleichzeitig die Verwendung bestehender Elektronikmodule erlaubt.

### LÖSUNG DER AUFGABE

Diese Aufgabe wird durch einen Modulträger mit den Merkmalen des Anspruchs 1 gelöst. Vorteilhafte Ausführungsformen sind in den abhängigen Ansprüchen angegeben.

Der erfindungsgemäße Modulträger umfasst eine Montageseite zur Montage auf einer Montageplatte, eine der Montageseite gegenüberliegende Aufnahmeseite für das Elektronikmodul, sowie eine linke Seite, eine rechte Seite, ein oberes Ende und ein unteres Ende. Zur Befestigung auf der Montageplatte sind im Bereich des oberen und unteren Endes Befestigungsmittel angeordnet.

Das wesentliche Merkmal der Erfindung besteht darin, dass das Befestigungsmittel ein bewegliches Betätigungsteil aufweist, das in einem Führungsteil angeordnet ist. Das Betätigungsteil kann von der Aufnahmeseite durch Druck auf eine Bedienfläche in Richtung der Montageseite verschoben werden. Es weist einen elastischen Rasthaken mit einer Rastnase auf, der in einer ersten Stellung gegen eine Innenfläche des Führungsteils gedrückt wird. In einer zweiten Stellung durchdringt der Rasthaken mit der Rastnase eine Ausnehmung im Führungsteil und eine Öffnung in der Montageplatte.

Ein Rückstellmittel zwischen der Montageseite und dem Betätigungsteil führt das Betätigungsteil in eine Verriegelungs-stellung zurück, in der die Rastnase gegen die Montageplatte drückt. Diese Konstruktion ermöglicht eine einfache Montage und Demontage des Modulträgers, sowie einen zuverlässigen Toleranzausgleich bei unterschiedlichen Plattendicken.

Der Modulträger weist zudem Aufnahmemittel für das Elektronikmodul auf, bestehend aus zwei gegenüberliegenden Halteelementen, zwischen denen das Modul einsteckbar ist. Dies gewährleistet eine sichere Fixierung des Elektronikmoduls.

Zur Integration in ein Bussystem verfügt der Modulträger über einen Bussteckverbinder-Raum mit einem verschiebbaren Bussteckverbinder. Dieser umfasst einen linksseitigen Stecker, einen rechtsseitigen Stecker und einen zur Aufnahmeseite angeordneten Rückwandbus-Stecker. Diese Konfiguration ermöglicht die flexible Verbindung mehrerer Modulträger zu einem modular aufbaubaren Automatisierungssystem.

Ein Signalsteckverbinder-Raum ist als Ausnehmung in der Montageseite ausgestaltet, um Platz für einen auf der Montageplatte befindlichen Signalsteckverbinder zu bieten. Dies erlaubt, eine kompakte Bauweise und effiziente Signalführung.

Weitere vorteilhafte Ausgestaltungen umfassen eine strukturierte Oberfläche der Bedienfläche für bessere Handhabung, die Verwendung von elastischem Material für das Betätigungsteil zur Erhöhung der Flexibilität, sowie eine Führungsnut im Führungsteil zur präzisen Bewegungsführung des Betätigungsteils.

Die beschriebene Erfindung bietet somit eine Lösung, die eine einfache und flexible Montage von Elektronikmodulen in Automatisierungssystemen ermöglicht, dabei einen zuverlässigen Toleranzausgleich gewährleistet und gleichzeitig die Verwendung bestehender Modultypen erlaubt.

Die Zeichnung zeigt ein Ausführungsbeispiel der Erfindung. Dabei zeigen
- FIG 1: einen Modulträger in einer perspektivischen Ansicht mit Sicht auf eine Linkeseite,
- FIG 2: den Modulträger in einer perspektivischen Ansicht mit Sicht auf eine Rechteseite,
- FIG 3: den Modulträger in einer Explosionszeichnung,
- FIG 4: eine Schnittdarstellung durch ein Führungsteil und ein Betätigungsteil
- FIG 5: ein Betätigungsteil
- FIG 6: einen Bussteckverbinder,
- FIG 7: der Modulträger mit Blick auf die Montageseite und
- FIG 8: eine perspektivische Darstellung eines Modulträgers mit eingestecktem Elektronikmodul.

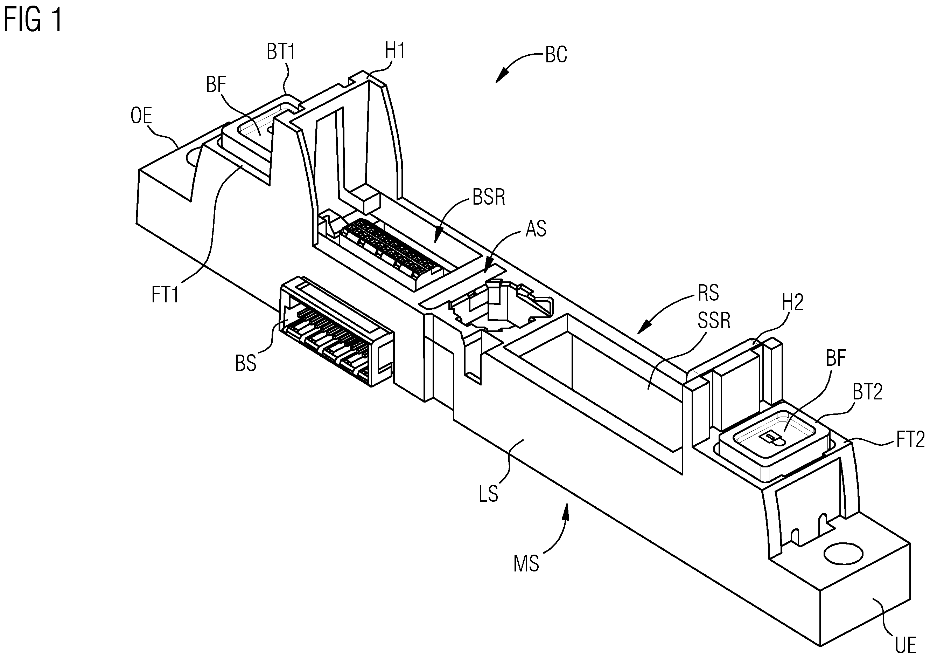

Gemäß FIG 1 ist ein Modulträger BC in einer perspektivischen Darstellung mit einer Sicht auf einer Linkeseite LS des Modulträgers BC dargestellt. Der Modulträger BC dient zur späteren Aufnahme eines Elektronikmoduls EM. Dazu umfasst der Modulträger BC eine Montageseite MS, ausgestaltet zur Montage auf einer Montageplatte MP, die Linkeseite LS, eine Rechteseite RS und eine Aufnahmeseite AS für das Elektronikmodul EM, welche der Montageseite MS gegenüberliegt. Des Weiteren weist der Modulträger BC ein oberes Ende OE und ein unteres Ende UE auf. Für eine Befestigung auf einer Montageplatte weist das obere Ende OE und das untere Ende UE jeweils eine Durchgangsbohrung auf. Für eine schnellere und einfachere Befestigung auf der Montageplatte MP weist der Modulträger BC nun im Bereich des oberen Endes OE ein erstes Befestigungsmittel BT1 und im Bereich des unteren Endes UE ein zweites Befestigungsmittel BT2 auf.

Das erste Befestigungsmittel BT1 und das zweite Befestigungsmittel BT2 sind derart ausgestaltet, dass jeweils ein Betätigungsteil BT1,BT2 beweglich in jeweils einem Führungsteil FT1,FT2 angeordnet ist. Dabei ist das Führungsteil FT1,FT2 ausgestaltet, dass sich das Betätigungsteil BT1,BT2 von der Aufnahmeseite AS durch Druck auf eine Bedienfläche BF durch eine Montageperson in Richtung der Montageseite MS verschieben lässt.

Hat nun eine Montageplatte MP, beispielsweise eine mehrlagige Leiterplatte, an der entsprechenden Stelle bereits eine Verrastbohrung, so kann mittels der Betätigungsteile BT1,BT2, welche jeweils einen Rasthaken RH aufweisen, der Modulträger BC rasch an der Leiterplatte befestigt werden.

Der Rasthaken RH ist dabei derart elastisch ausgebildet, dass er in einer ersten Stellung S1 des Betätigungsteils BT1,BT2 bereits eine Federkraft im Inneren des Führungsteils FT1,FT2 ausübt.

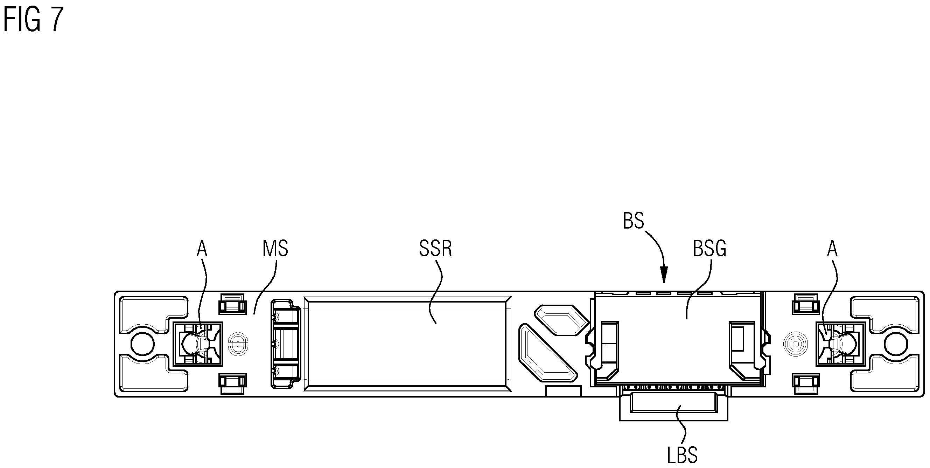

Da das Führungsteil FT1,FT2 eine in der Montageseite MS angeordnete Ausnehmung A aufweist (siehe FIG 7), kann der Rasthaken RH in einer zweiten Stellung S2 des Betätigungsteils BT1,BT2 mit seiner Rastnase RN die Ausnehmung A pasieren und in einer Öffnung O der Montageplatte MP eindringen bzw. durch sie hindurch dringen. Da der Rasthaken RH elastisch ausgebildet ist, wird er nun mit seiner Rastnase RN aus der Leiterplatte bzw. aus der Montageplatte MP herausspringen und sich hinter dieser Verhaken.

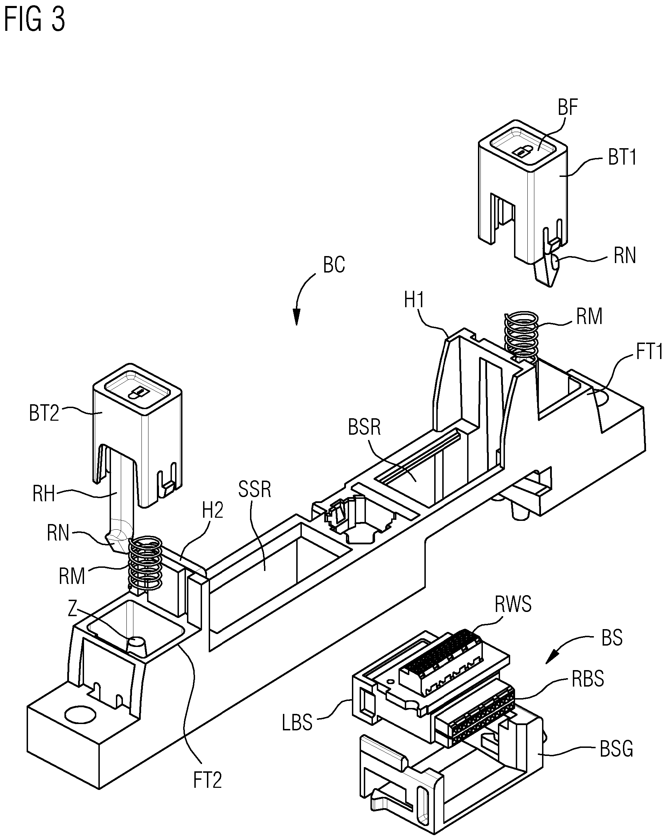

Zwischen der Montageseite MS, innerhalb des Führungsteils FT1,FT2, und dem Betätigungsteil BT1,BT2 ist ein Rückstellmittel RM angeordnet (siehe hierzu auch FIG 3, FIG 4 und FIG 5). In diesen Beispielen ist das Rückstellmittel RM als eine Spiralfeder ausgestaltet. Da die Spiralfeder zwischen dem Betätigungsteil BT1,BT2 und dem Führungsteil FT1,FT2 angeordnet ist, wird es das Betätigungsteil BT1,BT2 in Richtung der Aufnahmeseite AS zurückdrücken, nach dem eine Montageperson keinen Druck mehr auf die Bedienfläche BF ausübt. Nun kann das Betätigungsteil BT1,BT2 in einer Verriegelungsstellung SV derart verharren, dass die Rastnase RN gegen die Montageplatte MP drückt. Der Modulträger BC ist somit sicher auf der Montageplatte MP fixiert.

Zum sicheren Halten eines Elektronikmoduls EM, weist der Modulträger BC ein erstes Haltemittel H1 und ein zweites Haltemittel H2 auf.

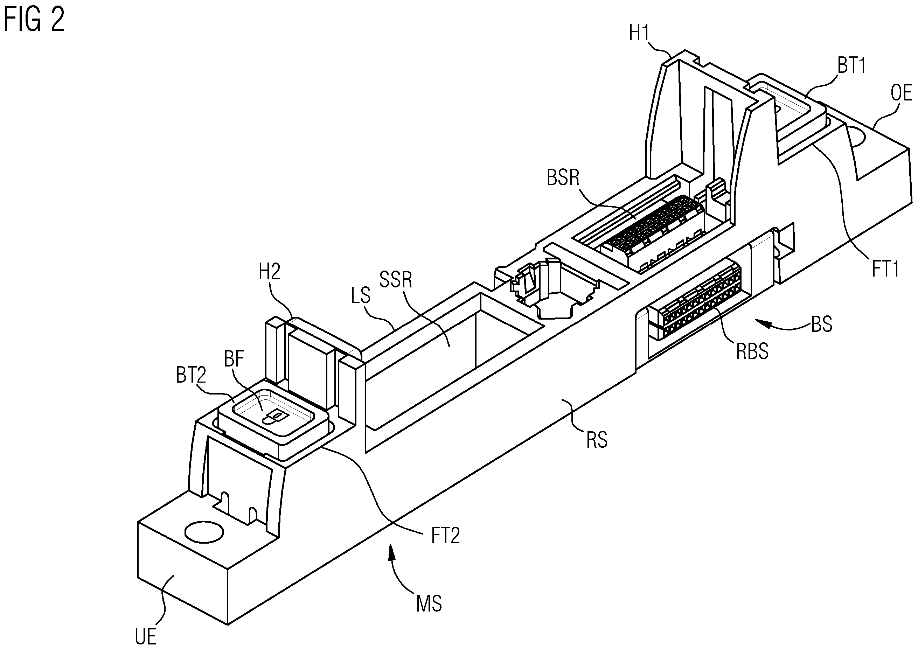

Gemäß FIG 2 ist der bereits bekannte Modulträger BC aus FIG 1, in einer anderen perspektivischen Darstellung mit Blick auf seine Rechteseite RS abgebildet. Wie auch in FIG 1 bereits gezeigt, weist der Modulträger BC einen Bussteckverbinder-Raum BSR und einen Signalsteckverbinder-Raum SSR auf. In dem Bussteckverbinder-Raum BSR ist ein Bussteckverbinder BS angeordnet und der Signalsteckverbinder-Raum SSR ist als Ausnehmung in der Montageseite MS ausgestaltet, um im montierten Zustand Raum für einen auf der Montageplatte MP befindlichen Signalsteckverbinder zu geben.

Der Modulträger BC nach FIG 1 oder FIG 2 ist ausgestaltet, durch Aneinanderreihen von einer Vielzahl von Modulträgern BC ein modular aufbaubares Automatisierungssystem zusammenzustellen. Die Bussteckverbinder BS sind dabei derart ausgestaltet, dass sie sich verschieben lassen und somit kann für mehrere Modulträger BC ein interner Rückwandbus durch die Bussteckverbinder BS aufgebaut werden.

Die FIG 3 verdeutlicht in einer Explosionsdarstellung des Modulträger BC noch einmal die Einbaulagen der Betätigungsteile BT1,BT2 und der Führungsteile FT1,FT2, insbesondere aber den verschiebbaren Einbau des Bussteckverbinders BS.

Der Bussteckverbinder BS ist wiederum in ein Bussteckverbinder-Gehäuse BSG eingebettet. Der Bussteckverbinder-Raum BSR innerhalb des Modulträgers BC und der Bussteckverbinder BS sind derart ausgestaltet, dass der Bussteckverbinder BS mit seinem Bussteckverbinder-Gehäuse BSG in dem Bussteckverbinder-Raum BSR verschiebbar angeordnet ist. Der Bussteckverbinder BS umfasst dabei einen zur Linkeseite LS angeordneten Linksseitigen-Stecker LBS, einen zur Rechteseite RS angeordneten Rechtsseitigen-Stecker RBS und zur Aufnahmeseite AS angeordneten Rückwandbus-Stecker RWS.

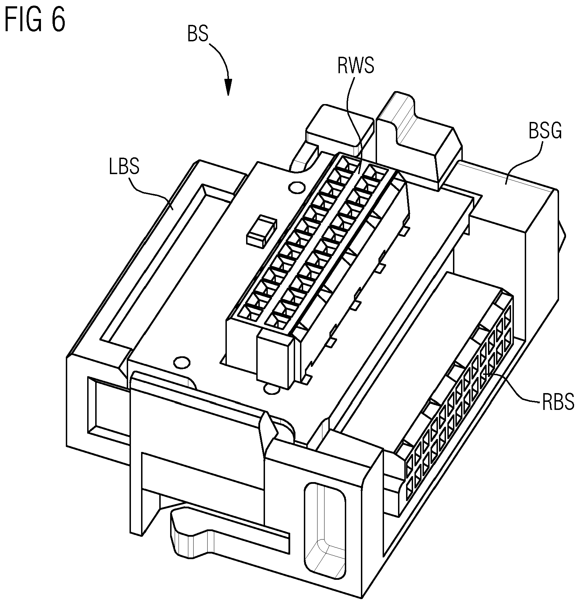

Unter Zuhilfenahme von FIG 6 kann nun der technische Effekt für das verschiebbare angeordnete Bussteckverbinder-Gehäuse BSG erläutert werden. Das Bussteckverbinder-Gehäuse BSG ist ausgestaltet, mit dem entsprechend ausgestalteten Bussteckverbinder-Raum BSR bei einer Linksverschiebung einzurasten, so dass der Linksseitige-Stecker LBS mit einem jeweiligen Rechtsseitigen-Stecker RBS eines Bussteckverbinders BS eines Vorgängermodulträger im Eingriff steht und dass sich der Rückwandbus-Stecker RWS in einer Mittelstellung befindet, damit ein über die Aufnahmeseite AS einsteckbares Elektronikmodul EM mit einem Gegenrückwandbus-Stecker GRS mit dem Rückwandbus-Stecker RWS im Kontakt steht.

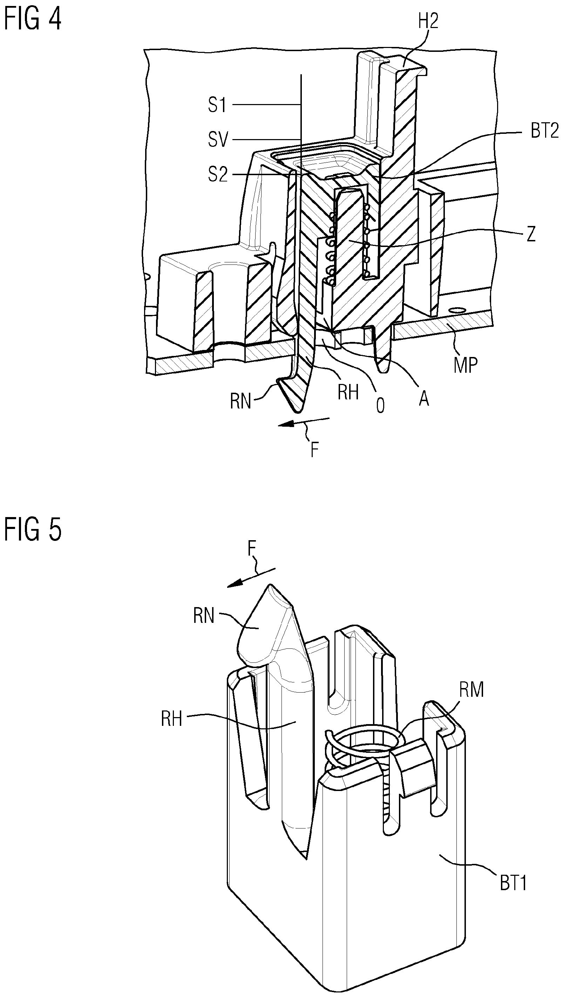

Mit der FIG 4 wird in einer Schnittdarstellung durch den Modulträger BC mit Blick auf das zweite Führungsteil FT2 und das zweite Bedienteil BT2, die Funktion des Rasthakens RH mit seiner Rastnase RN bei Druck auf die Bedienfläche BF durch eine Montageperson klar. Das zweite Betätigungsteil BT2 wird durch Druck auf die Bedienfläche BF von einer ersten Position S1 in eine zweite Position S2 verschoben. Die zweite Position S2 bzw. die zweite Stellung S2 ist derart tief angeordnet, dass der Rasthaken RH mit seiner Rastnase RN das zweite Führungsteil FT2 bzw. dessen Innenseite verlässt und durch eine Ausnehmung A hindurch durch eine Verrastbohrung in der Montageplatte MP dringt und sich nun die elastische Federkraft des Rasthakens RH bemerkbar macht und der Rasthaken RH mit der Kraft F gegen die Leiterplatte drückt. Wird die Bedienperson den Druck auf die Bedienfläche BF nachlassen, so verruscht das zweite Betätigungsteil BT2 in eine Verriegelungsstellung SV und die Rastnase RN drückt den Modulträger BC an die Leiterplatte heran. Da zwischen dem zweiten Bedienteil BT2 und dem zweiten Führungsteil FT2 ein Rückstellmittel RM auf einem Zapfen Z angeordnet ist, wird das zweite Bedienteil BT2 bei nachlassendem Druck nach oben gedrückt.

Die FIG 5 verdeutlicht das erste Betätigungsteil BT1 in einer perspektivischen Darstellung als ein Kunststoffspritzgussteil mit seinem entsprechenden Rasthaken RH und seiner Rastnase RN, wobei die Rastnase RN und der Rasthaken RH derart elastisch ausgeformt wird, dass eine Kraft F in der Richtung wie eingezeichnet entsteht. Als Rückstellmittel RM wird eine Spiralfeder im Inneren des ersten Betätigungsteils BT1 angeordnet.

Die FIG 6 zeigt wiederum in einer perspektivischen Darstellung den Bussteckverbinder BS, wie er in dem Bussteckverbinder-Gehäuse BSG angeordnet ist. Das Bussteckverbinder-Gehäuse BSG weist ebenfalls Verrasthaken mit Rastnasen auf, welche dazu dienen, wie mit FIG 7 mit Blick auf die Montageseite MS gezeigt, in entsprechende Verrastöffnungen in dem Modulträger BC einzurasten.

Wie in FIG 7 gezeigt ist der Modulträger BC mit Blick auf die Montageseite MS dargestellt. Der Bussteckverbinder BS mit seinem Bussteckverbinder-Gehäuse BSG ist bereits ganz in den Modulträger BC nach links eingeschoben worden, wobei die erwähnten Verrasthaken und Verrastnasen aus FIG 6 in einer Stellung eingerastet sind, so dass der Linksseitige-Stecker LBS aus dem Modulträger BC herausragt. Wäre nun an dieser Stelle ein weiterer Modulträger BC angeordnet, so würde der Linksseitige-Stecker LBS in den entsprechenden Rechtsseitigen-Stecker RBS des benachbarten Modulträgers BC einrasten.

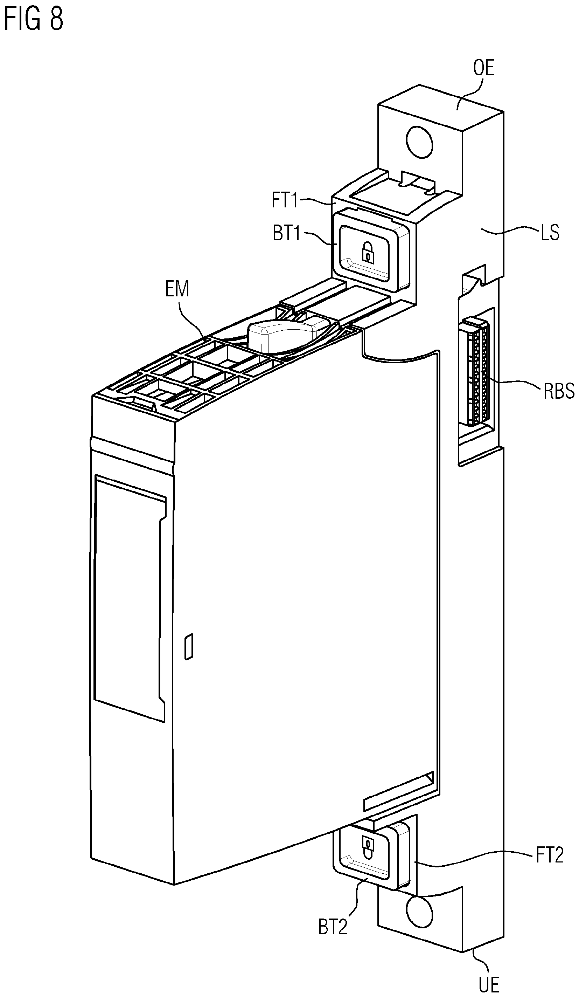

Abschließend sei mit FIG 8 die Einheit Elektronikmodul EM und Modulträger BC dargestellt. Die Bedienflächen BF der Bedienteile BT1,BT2 sind mit einer strukturierten Oberfläche versehen. In diesem Ausführungsbeispiel ist die strukturierte Oberfläche in Form eines Schlosses dargestellt, welches zum Ausdruck bringt, wenn man dieses drückt, wird hier verriegelt.

Zusammenfassend kann gesagt werden:
Die Verrastung von Baugruppen auf Leiterplatten stellt mehrere Herausforderungen dar, darunter Toleranzausgleich, Funktionalität bei unterschiedlichen Leiterplattendicken und die Notwendigkeit einer fertigungsfreundlichen Rastkontur. Leiterplatten haben typischerweise eine Toleranz von 10% der Nennmaßdicke, was die Verrastung erschwert. Kundenspezifische Anforderungen erfordern die Verwendung verschiedener Leiterplattendicken.

Ein Mitbewerberprodukt verwendet nicht-gefederte Kunststoff-rasthaken, die nur für 1,6mm dicke Leiterplatten geeignet sind und keinen Toleranzausgleich bieten. Für dickere Leiterplatten ist eine kostenintensive Tiefenfräsung erforderlich.

Die vorgestellte Lösung besteht aus einem Rückstellmittel, insbesondere aus einer Metallfeder, und einem Kunststoffteil mit abgerundetem Rasthaken. Diese Konstruktion ermöglicht die Verwendung von Leiterplatten mit beispielsweise 1,6mm bis 2,7mm Nennmaß (±10% Toleranz).

Der Rasthaken greift durch eine Bohrung in der Leiterplatte und wird durch die Feder gegen die Rückseite gedrückt.

Hauptvorteile dieser Lösung sind:
1. Vollständiger Toleranzausgleich durch Federlagerung.
2. Spielfreie Montage auf unterschiedlich dicken Leiterplatten.
3. Konstante Federkraft für sichere Befestigung.
4. Flexibilität bei der Verwendung verschiedener Leiterplattendicken.
5. Unterstützung kostengünstiger Fertigungsmethoden durch Bohrungen statt Fräsungen.

Diese Lösung unterscheidet sich vom Mitbewerberprodukt durch den Einsatz eines Federelements in Kombination mit einem Rasthaken, was einen besseren Toleranzausgleich und höhere Vielseitigkeit bietet.

## Patentansprüche

1. Modulträger (BC) ausgestaltet ein Elektronikmodul (EM) aufzunehmen, umfassend
- eine Montageseite (MS) ausgestaltet zu Montage auf einer Montageplatte (MP),
- eine Linkeseite (LS),
- eine Rechteseite (RS),
- eine Aufnahmeseite (AS) für das Elektronikmodul (EM), welche der Montageseite (MS) gegenüberliegt,
- ein oberes Ende (OE) und
- ein unteres Ende (UE),
wobei zur Befestigung auf der Montageplatte (MP) im Bereich des oberen Endes (OE) ein erstes Befestigungsmittel (BT1) angeordnet ist und im Bereich des unteren Endes (UE) ein zweites Befestigungsmittel (BT2) angeordnet ist,
**dadurch gekennzeichnet, dass** das Befestigungsmittel derart ausgestaltet ist, dass ein Betätigungsteil (BT1,BT2) beweglich in einem Führungsteil (FT1,FT2) angeordnet ist, dabei ist das Führungsteil (FT1,FT2) ausgestaltet, dass das Betätigungsteil (BT1,BT2) von der Aufnahmeseite (AS) durch Druck auf eine Bedienfläche (BF) durch eine Montageperson in Richtung der Montageseite (MS) verschiebbar ist, wobei das Betätigungsteil (BT1,BT2) einen Rasthaken(RH) aufweist, welcher derart elastisch ausgebildet ist, dass in einer ersten Stellung (S1) des Betätigungsteils (BT1,BT2) eine Federkraft des Rasthakens(RH) eine am Ende des Rasthakens (RH) angeordnete Rastnase (RN) gegen eine Innenfläche des Führungsteils (FT1,FT2) drückt, wobei das Führungsteil (FT1,FT2) eine in der Montageseite (MS) angeordnete Ausnehmung (A) aufweist, wobei in einer zweiten Stellung (S2) des Betätigungsteils (BT1,BT2) der Rasthaken (RH) mit der Rastnase (RN) die Ausnehmung (A) und eine Öffnung (O) in der Montageplatte (MP) durchdringt, wobei zwischen der Montageseite (MS) innerhalb des Führungsteils (FT1,FT2) und dem Betätigungsteil (BT1,BT2) ein Rückstellmittel (RM) angeordnet ist, welches das Betätigungsteil (BT1,BT2) in Richtung der Aufnahmeseite (AS) derart zurückführt, dass das Betätigungsteil (BT1,BT2) in einer Verriegelungsstellung (SV) verharrt und die Rastnase (RN) gegen die Montageplatte (MP) drückt.

2. Modulträger (BC) nach Anspruch 1, aufweisend ein Aufnahmemittel für das Elektronikmodul (EM) umfassend ein erstes Haltelement (H1) und ein zweites Halteelement (H2) die Halteelemente (H1,H2) sind sich derart gegenüber angeordnet, dass das Elektronikmodul (EM) dazwischen einsteckbar ist.

3. Modulträger (BC) nach Anspruch 1 oder 2, aufweisend einen Bussteckverbinder-Raum (BSR) und einen Signalsteckverbinder-Raum (SSR), wobei in dem Bussteckverbinder-Raum (BSR) ein Bussteckverbinder (BS) angeordnet ist und der Signalsteckverbinder-Raum (SSR) ist als Ausnehmung in der Montageseite (MS) ausgestaltet, um in einem montierten Zustand Raum für einen auf der Montageplatte (MP) befindlichen Signalsteckverbinder zu geben.

4. Modulträger (BC) nach einem der Ansprüche 1 bis 3, ausgestaltet durch Aneinanderreihen von einer Vielzahl von Modulträgern (BC) ein modular aufbaubares Automatisierungssystem zusammenzustellen.

5. Modulträger (BC) nach Anspruch 4, wobei der Bussteckverbinder-Raum (BSR) und der Bussteckverbinder (BS) ausgestaltet sind, dass der Bussteckverbinder (BS) in dem Bussteckverbinder-Raum (BSR) verschiebbar angeordnet ist, dabei umfasst der Bussteckverbinder (BS) einen zur Linkeseite (LS) angeordneten Linksseitigen-Stecker (LBS), einen zur Rechteseite (RS) angeordneten Rechtsseitigen-Stecker (RBS) und einen zur Aufnahmeseite (AS) angeordneten Rückwandbus-Stecker (RWS).

6. Modulträger (BC) nach einem der Ansprüche 1 bis 5, wobei ein Bussteckverbinder-Gehäuse (BSG) als eine Aufnahme für den Bussteckverbinder (BS) ausgestaltet ist, und dabei ist das Bussteckverbinder-Gehäuse (BSG) ausgestaltet mit dem entsprechend ausgestalteten Bussteckverbinder-Raum (BSR) bei einer Linksverschiebung einzurasten, so dass der Linksseitige-Stecker (LBS) mit einem Rechtsseitigen-Stecker (RBS) eines Bussteckverbinders (BS) eines Vorgänger-Modulträgers im Eingriff steht und das sich der Rückwandbus-Stecker (RWS) in einer Mittelstellung befindet, damit ein über die Aufnahmeseite (AS) einsteckbares Elektronikmodul (EM) mit einem Gegen-Rückwandbus-Stecker mit dem Rückwandbus-Stecker (RWS) im Kontakt steht.

7. Modulträger (BC) nach einem der vorhergehenden Ansprüche, wobei die Bedienfläche (BF) eine strukturierte Oberfläche aufweist.

8. Modulträger (BC) nach einem der vorhergehenden Ansprüche, wobei das Betätigungsteil (BT1,BT2) aus einem elastischen Material gefertigt ist.

9. Modulträger (BC) nach einem der vorhergehenden Ansprüche, wobei das Führungsteil (FT1,FT2) eine Führungsnut aufweist, in der sich das Betätigungsteil (BT1,BT2) bewegt.

10. Modulträger (BC) nach einem der vorhergehenden Ansprüche, wobei die Ausnehmung (A) eine abgerundete Form aufweist.

11. Modulträger (BC) nach einem der vorhergehenden Ansprüche, wobei der Rasthaken (RH) eine abgeschrägte Kante aufweist, um das Einführen in die Öffnung (O) der Montageplatte (MP) zu erleichtern.
